# EUROPEAN PATENT APPLICATION

(11) **EP 2 674 985 A1**
(43) Date of publication of application: **18.12.2013**
(21) Application number: 12744277.0
(22) Date of filing: 17.01.2012
(51) Int. Cl.: H01L 31/04

(54) **THIN-FILM SOLAR CELL AND METHOD OF MANUFACTURING THEREOF**

(30) Priority: 09.02.2011 JP 2011025953
(71) Applicant: Fuji Electric Co., Ltd., Kawasaki-shi Kanagawa 210-9530 (JP)
(72) Inventor: NAKAMURA, Hideyo, Kawasaki-shi Kanagawa 210-9530 (JP)
(74) Representative: Appelt, Christian W.
(86) International application number: PCT/JP2012/050791
(87) International publication number: WO 2012/108231

(57) **Abstract**

In a thin-film photovoltaic cell 1 of the present invention, a rear electrode layer 3a, a photoelectric conversion layer 4, and a transparent electrode layer 5 are stacked in this order on a surface 2a of an insulating substrate 2, and a first back electrode layer 3b and a second back electrode layer 6 are stacked in this order on a surface 2b of the insulating substrate 2. The transparent electrode layer 5 and the second back electrode layer 6 are electrically connected to each other by a first through-hole 7 that penetrates through the insulating substrate 2. The rear electrode layer 3a and the first back electrode layer 3b are electrically connected to each other by a second through-hole 8 that penetrates through the insulating substrate 2. The transparent electrode layer 5 around the second through-hole 8 is removed, and the transparent electrode layer 5 and the second back electrode layer 6 are electrically insulated from each other at the second through-hole 8.

## Description

### TECHNICAL FIELD

The present invention relates to a thin-film photovoltaic cell formed by stacking a metal electrode layer, a photoelectric conversion layer, and a transparent electrode layer on a film substrate.

### BACKGROUND ART

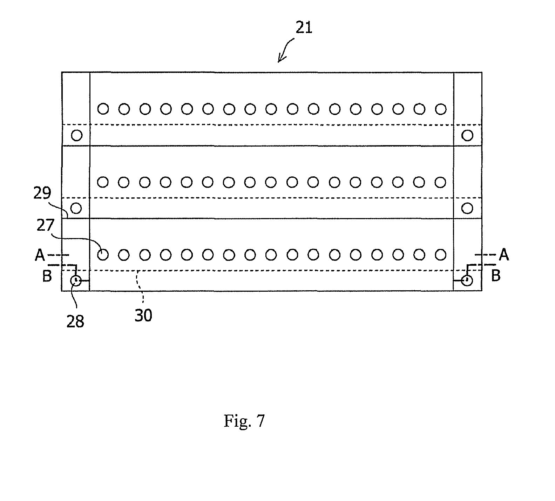

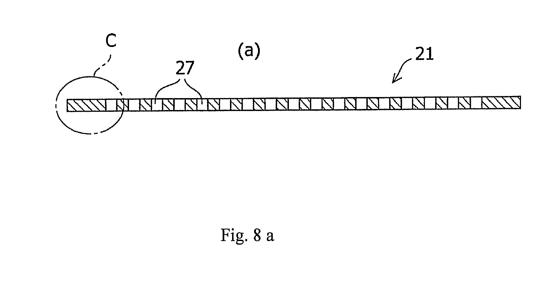

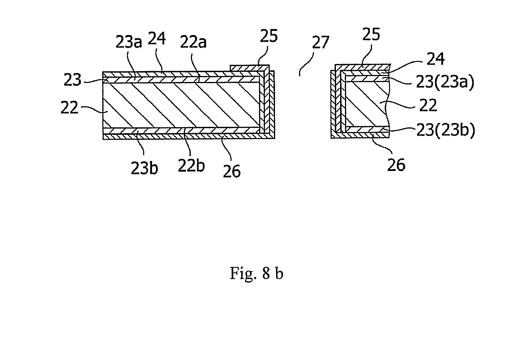

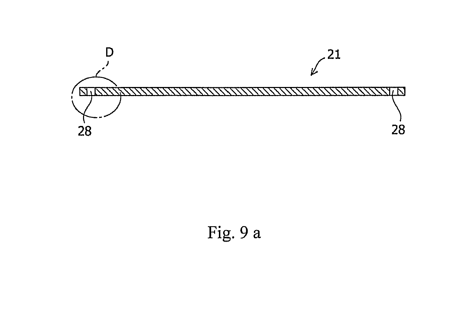

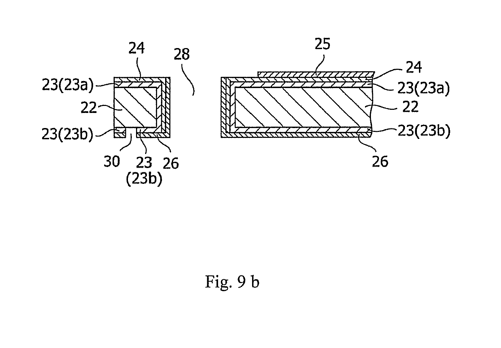

Fig. 7 is a plan view of a conventional thin-film photovoltaic cell. Fig. 8 is a cross-sectional diagram taken along line A-A of Fig. 7. Fig. 9 is a cross-sectional diagram taken along line B-B of Fig. 7.
As shown in Figs. 8 and 9, the conventional thin-film photovoltaic cell 21 has an insulating substrate 22, wherein metal electrode layers 23 are formed on surfaces 22a, 22b of the insulating substrate 22. The metal electrode layer 23 on the surface 22a of the insulating substrate 22 functions as a rear electrode layer 23a, and the metal electrode layer 23 on the surface 22b of the insulating substrate 22 as a first back electrode layer 23b.

Also, as shown in Figs. 8 and 9, a photoelectric conversion layer 24 and a transparent electrode layer 25 are stacked on the rear electrode layer 23a in this order. A second back electrode layer 26 is stacked on the first back electrode layer 23b.
As shown in Figs. 7 and 8, the insulating substrate 22 is provided with first through-holes 27 penetrating through the insulating substrate 22. The transparent electrode layer 25 and the second back electrode layer 26 are electrically connected to each other by the first through-holes 27. Furthermore, as shown in Figs. 7 and 9, the insulating substrate 22 is provided with second through-holes 28 penetrating through the insulating substrate 22. The rear electrode layer 23a and the first back electrode layer 23b are electrically connected to each other by the second through-holes 28.

As shown in Fig. 7, the layers stacked on the surface 22a of the insulating substrate 22 are divided by first patterning lines 29, and the layers stacked on the surface 22b of the insulating substrate 22 by second patterning lines 30 (see Fig. 9(b)). Consequently, the layers stacked on the insulating substrate 22 are divided into a plurality of unit cells.
In this case, the first and second patterning lines 29 and 30 alternate with each other on the insulating substrate 22. The unit cells adjacent from each other are connected in series by shifting the positions where the surfaces 22a, 22b of the insulating substrate 22 separate from each other and connecting the electrode layers on the surfaces 22a, 22b of the insulating substrate 22 to each other by the second through-holes 28.

Patent Document 1 discloses another example of a - conventional thin-film photovoltaic cell. In the thin-film photovoltaic cell of Patent Document 1, a first electrode layer, a photoelectric conversion layer, and a second back electrode layer are stacked on one surface of a film substrate made of electrical insulating resin, and a third electrode layer and fourth electrode layer are stacked on the other side (rear surface) of the film substrate.

Patent Document 2 discloses yet another example of a thin-film photovoltaic cell. In the thin-film photovoltaic cell of Patent Document 2, a connection hole is sealed with a printed electrode made of a conductive material (see, particularly, the paragraph 0035 and Fig. 27).

Patent Document 1: Japanese Patent Application Publication No. 2001-298203
Patent Document 2: Japanese Patent Application Publication No. H6-342924

Unfortunately, the configurations shown in Figs. 7 to 9 have the following problems.
In the conventional structure, when forming the transparent electrode layer 26 in order to prevent the transparent electrode layer 25 and the second back electrode layer 26 from coming into contact with each other at the second through-holes 28, mask processing using a metal mask is performed in the vicinity of each of the second through-holes 28. Use of a metal mask needs to take into consideration the manufacturing conditions for the mask processing and latitude for wrap-around of a film to be formed. For this reason, the area of the metal mask needs to be significantly greater than that of each of the second through-holes 28. Thus, the vicinity of each of the second through-holes 28 has a part where the transparent electrode layer 25 is not formed, as shown in Fig. 9 (b), limiting the effective area of the transparent electrode layer 25.
The structure, therefore, needs to secure the effective area of the transparent electrode layer 25.

When forming a plurality of the second through-holes 28 per unit cell, the second through-holes 28 are disposed at regular intervals, in consideration of the electrical resistances of the first and second back electrode layers 23b and 26. As a result, regions where the transparent electrode layer 25 cannot be formed are provided at regular intervals on the insulating substrate 22. When the number of the second through-holes 28 is increased, the effective area of the transparent electrode layer 25 decreases proportionally, reducing the output of the thin-film photovoltaic cell 21.
Reducing the number of the adjacent second through-holes 28 and increasing the intervals therebetween in order to relatively increase the effective area of the transparent electrode layer 25 increases the distance between the wirings in each unit cell and hence the electrical resistances. In addition, more current concentrates on a single second through-hole. This results in a further voltage drop and loss of the output of the thin-film photovoltaic cell.
Therefore, a structure that prevents concentration of current in the second through-holes 28 and increase of the electrical resistances while securing the effective area of the transparent electrode layer is required.

When performing the mask processing in the vicinity of each of the second through-holes 28, the transparent electrode layer 25 or the like on the insulating substrate 22 comes into contact with the mask, damaging the transparent electrode layer 25 or the like on the insulating substrate 22. When any of the layers on the insulating substrate 22 is damaged, leak current or the like increases, increasing the failure rate in manufacturing the thin-film photovoltaic cell 21.

A problem of the technology disclosed in Patent Document 2 is the increase in leak current caused by insufficient insulation of the connection hole sealed with the conductive material. Moreover, the technology disclosed in Patent Document 2 needs to ensure flatness of the material filling the connection hole.

The mask processing for forming the transparent electrode layer 25 does not have to be performed, by wrapping the photoelectric conversion layer 24 of the surface 22a of the insulating substrate 22 around the back and performing the mask processing on the second back electrode layer 26 of the surface 22b of the insulating substrate 22. Consequently, it is considered that the effective area can be enlarged.
However, because the second through-holes 28 are punched (a perforating method) or mechanically fabricated, acute-angled protrusions or the like are formed on the edges of the holes. Therefore, the photoelectric conversion layer 24 is damaged even when the photoelectric conversion layer 24 is formed over the edges of the second through-holes 28. Especially when the photoelectric conversion layer 24 is damaged, leak current occurs between the transparent electrode layer 26 and the rear electrode layer 23a due to a large potential difference therebetween.
Even when the mask processing is performed on the second back electrode layer 26 instead of on the transparent electrode layer 25, leak current or the like increases, increasing the failure rate in manufacturing the thin-film photovoltaic cell 21.

### DISCLOSURE OF THE INVENTION

The present invention was contrived in view of the circumstances described above, and an object thereof is to provide a thin-film photovoltaic cell and a method for producing the same, the method being capable of increasing the effective area of a transparent electrode layer, increasing the output of the thin-film photovoltaic cell by suppressing increase in wiring resistance, and reducing the failure rate in manufacturing the thin-film photovoltaic cell by ensuring insulation of a second through-hole.

In order to solve the problems of the conventional technologies, the present invention provides a thin-film photovoltaic cell, having: an insulating substrate; a rear electrode layer, a photoelectric conversion layer, and a transparent electrode layer stacked in this order on one surface of the insulating substrate; a first back electrode layer and a second back electrode layer stacked in this order on the other surface of the insulating substrate; patterning lines that are formed alternately on the layers stacked on both surfaces of the insulating substrate, thereby dividing the insulating substrate into a plurality of unit cells; a first through-hole that penetrates through the insulating substrate to electrically connect the transparent electrode layer and the second back electrode layer to each other; and a second through-hole that penetrates through the insulating substrate to electrically connect the rear electrode layer and the first back electrode layer to each other, the unit cells adjacent to each other being connected in series, wherein the transparent electrode layer around the second through-hole is removed, and the transparent electrode layer and the second back electrode layer are electrically insulated from each other at the second through-hole.

According to the thin-film photovoltaic cell of the present invention, the transparent electrode layer around the second through-hole is removed by sandblasting.

According to the thin-film photovoltaic cell of the present invention, the patterning lines that are disposed alternately are formed into straight lines and extend in a direction parallel to a width direction of the insulating substrate. A plurality of the second through-holes are disposed at equal intervals between the patterning lines that are disposed alternately. A distance between an end part of the insulating substrate in the width direction and a center of the second through-hole closest to the end part is half the interval between the second through-holes. A distance between the center of the second through-hole and either one of the patterning lines is equal to a distance between the center of the second through-hole and another patterning line.

According to the thin-film photovoltaic cell of the present invention, the patterning lines that are disposed alternately are formed into straight lines and extend in a direction parallel to a width direction of the insulating substrate. The second through-hole is disposed singly between the patterning lines that are disposed alternately. A distance between a center of the second through-hole and one end part of the insulating substrate in the width direction is equal to a distance between the center of the second through-hole and the other end part of the insulating substrate in the width direction. A distance between the center of the second through-hole and either one of the patterning lines is equal to a distance between the center of the second through-hole and another patterning line.

In order to solve the problems of the conventional technologies, a method for producing a thin-film photovoltaic cell according to the present invention has the steps of: forming a second through-hole in an insulating substrate; forming a rear electrode layer on one surface of the insulating substrate and forming a first back electrode layer on the other surface of the insulating substrate; forming a first through-hole in the insulating substrate after forming the rear electrode layer and the first back electrode layer; stacking a photoelectric conversion layer and a transparent electrode layer on the one surface of the insulating substrate in this order and stacking a second back electrode layer on the other surface of the insulating substrate; forming patterning lines alternately on the layers stacked on both surfaces of the insulating substrate and dividing the insulating substrate into a plurality of unit cells; and removing the transparent electrode layer around the second through-hole and electrically insulating the transparent electrode layer and the second back electrode layer from each other at the second through-hole.

In the method for forming a thin-film photovoltaic cell according to the present invention, the step of removing the transparent electrode layer around the second through-hole is performed by sandblasting.

In the method for producing a thin-film photovoltaic cell according to the present invention, the step of forming a second through-hole forms a plurality of the second through-holes at equal intervals between positions where the alternating patterning lines are formed. The patterning lines are formed into straight lines in a direction parallel to a width direction of the insulating substrate. A distance between an end part of the insulating substrate in the width direction and a center of the second through-hole closest to the end part is half the interval between the second through-holes. A distance between the center of the second through-hole and either one of the patterning lines is equal to a distance between the center of the second through-hole and another patterning line.

In the method for producing a thin-film photovoltaic cell according to the present invention, the step of forming a second through-hole forms one second through-hole between positions where the alternating patterning lines are formed. The patterning lines are formed into straight lines in a direction parallel to a width direction of the insulating substrate. A distance between a center of the second through-hole and one end part of the insulating substrate in the width direction is equal to a distance between the center of the second through-hole and the other end part of the insulating substrate in the width direction. A distance between the center of the second through-hole and either one of the patterning lines is equal to a distance between the center of the second through-hole and another patterning line.

In the thin-film photovoltaic cell according to the present invention, a rear electrode layer, a photoelectric conversion layer, and a transparent electrode layer are stacked on one of surfaces of an insulating substrate in this order, and a first back electrode layer and a second back electrode layer are stacked on the other surface of the insulating substrate in this order. The insulating substrate is divided into a plurality of unit cells by forming patterning lines alternately on the layers stacked on both surfaces of the insulating substrate. The transparent electrode layer and the second back electrode layer are electrically connected to each other by a first through-hole penetrating through the insulating substrate. The rear electrode layer and the first back electrode layer are electrically connected to each other by a second through-hole penetrating through the insulating substrate. The unit cells adjacent to each other are connected in series. The transparent electrode layer around the second through-hole is removed, and the transparent electrode layer and the second back electrode layer are electrically insulated from each other at the second through-hole. For this reason, insulation between the transparent electrode layer and the second back electrode layer can be ensured at the second through-hole, without performing mask processing on the periphery of the second through-hole, unlike the conventional technologies. Moreover, instead of performing the mask processing on the periphery of the second through-hole, the transparent electrode layer is removed. Therefore, compared to when performing the mask processing, the area of a region without the transparent electrode layer can be reduced, increasing the effective area of the transparent electrode layer. As a result, the output of the thin-film photovoltaic cell can be increased.

In the thin-film photovoltaic cell according to the present invention, the patterning lines alternating with each other are formed into straight lines and extend in a direction parallel to a width direction of the insulating substrate. A plurality of the second through-holes are disposed at equal intervals between the patterning lines alternating with each other. The distance between an end part of the insulating substrate in the width direction and the center of the second through-hole closest to the end part is half the interval of the second through-holes. The distance between the center of the second through-hole and one of the patterning lines is equal to the distance between the center of the second through-hole and the other patterning line. According to the present invention, the area of a region without the transparent electrode layer is smaller than that obtained as a result of the mask processing. For this reason, the plurality of second through-holes can be disposed at intervals shorter than those obtained in the conventional technologies. Therefore, the distance between the wirings in each unit cell becomes short. Furthermore, the concentration of current in the second through-holes can be efficiently dispersed, preventing a voltage drop and loss of the output of the thin-film photovoltaic cell. Moreover, even when the plurality of second through-holes are provided in a single unit cell, the output of the thin-film photovoltaic cell can be made higher than those in the conventional technologies.

In the thin-film photovoltaic cell according to the present invention, the patterning lines alternating with each other are formed into straight lines and extend in a direction parallel to a width direction of the insulating substrate. The second through-hole is disposed singly between the patterning lines alternating with each other. The distance between the center of the second through-hole and one of end parts of the insulating substrate in the width direction is equal to the distance between the center of the second through-hole and the other end part of the insulating substrate in the width direction. The distance between the center of the second through-hole and one of the patterning lines is equal to the distance between the center of the second through-hole and the other patterning line. The present invention is particularly useful in a thin-film photovoltaic cell in which the width direction of the insulating substrate is short and a plurality of cells are disposed in the width direction of the insulating substrate. According to the configuration of the present invention, the effective area of the transparent electrode layer can be increased by simply removing the transparent electrode layer around the second through-hole.

The method for producing a thin-film photovoltaic cell according to the present invention includes the steps of: forming a second through-hole in an insulating substrate; forming a rear electrode layer on one surface of the insulating substrate and forming a first back electrode layer on the other surface of the insulating substrate; forming a first through-hole in the insulating substrate after forming the rear electrode layer and the first back electrode layer; stacking a photoelectric conversion layer and a transparent electrode layer on the one surface of the insulating substrate in this order and stacking a second back electrode layer on the other surface of the insulating substrate; forming patterning lines alternately on the layers stacked on both surfaces of the insulating substrate and dividing the insulating substrate into a plurality of unit cells; and removing the transparent electrode layer around the second through-hole and electrically insulating the transparent electrode layer and the second back electrode layer from each other at the second through-hole. Therefore, insulation can be ensured between the transparent electrode layer and the second back electrode layer at the second through-hole, without performing the mask processing on the periphery of the second through-hole as in the conventional technologies. In addition, because the transparent electrode layer is simply removed without performing the mask processing on the periphery of the second through-hole, the area of a region without the transparent electrode layer is smaller than that obtained as a result of the mask processing. Consequently, the effective area of the transparent electrode layer can be increased. As a result, the output of the thin-film photovoltaic cell can be increased.
Furthermore, because the mask processing does not have to be performed in the vicinity of the second through-hole, the layers on the insulating substrate can be prevented from being damaged by contact between the mask and the layers on the insulating substrate. Consequently, increase in leak current can be prevented, lowering the failure rate in manufacturing the thin-film photovoltaic cell.

According to the method for producing a thin-film photovoltaic cell, the step of removing the transparent electrode layer around the second through-hole is performed by sandblasting, thereby enabling the periphery of the second through-hole to be precisely processed.

Furthermore, in the method for producing a thin-film photovoltaic cell according to the present invention, the step of forming the second through-hole forms a plurality of the second through-holes at equal intervals between positions where the alternating pattern lines are formed. The patterning lines are formed into straight lines in a direction parallel to a width direction of the insulating substrate. The distance between an end part of the insulating substrate in the width direction and the center of the second through-hole closest to the end part is half the interval of the second through-holes. The distance between the center of the second through-hole and one of the patterning lines is equal to the distance between the center of the second through-hole and the other patterning line. According to the present invention, the area of a region without the transparent electrode layer is smaller than that obtained as a result of the mask processing. For this reason, the plurality of second through-holes can be disposed at intervals shorter than those obtained in the conventional technologies. Therefore, the distance between the wirings in each unit cell becomes short. Furthermore, the concentration of current in the second through-holes can be efficiently dispersed, preventing loss of the output of the thin-film photovoltaic cell. Moreover, even when the plurality of second through-holes are provided in a single unit cell, the output of the thin-film photovoltaic cell can be made higher than those in the conventional technologies.

In the method for producing a thin-film photovoltaic cell according to the present invention, the step of forming the second through-hole forms a single second through-hole between the positions where the alternating patterning lines are formed. The patterning lines alternating with each other are formed into straight lines in a direction parallel to the width direction of the insulating substrate. The distance between the center of the second through-hole and one of end parts of the insulating substrate in the width direction is equal to the distance between the center of the second through-hole and the other end part of the insulating substrate in the width direction. The distance between the center of the second through-hole and one of the patterning lines is equal to the distance between the center of the second through-hole and the other patterning line. The present invention is particularly useful in a thin-film photovoltaic cell in which the width direction of the insulating substrate is short and a plurality of cells are disposed in the width direction of the insulating substrate. According to the configuration of the present invention, the effective area of the transparent electrode layer can be increased by simply removing the transparent electrode layer around the second through-hole.

### BRIEF DESCRIPTION OF THE DRAWING

Figs. 1(a) and 1(b) are plan views of a thin-film photovoltaic cell according to a first embodiment of the present invention, Fig. 1(a) being a plan view showing the thin-film photovoltaic cell from the rear electrode layer side and Fig. 1(b) a plan view showing the thin-film photovoltaic cell from the first and second back electrode layers side;
Fig. 2 is a cross-sectional diagram taken along line A-A of Fig. 1;
Figs. 3(a) and 3(b) are cross-sectional diagrams taken along line B-B of Fig. 1, Fig. 3(a) being a cross-sectional diagram showing a state prior to removal of a transparent electrode layer and Fig. 3 (b) a cross-sectional diagram showing a state after removal of the transparent electrode layer;
Fig. 4 is a flowchart of a procedure for producing the thin-film photovoltaic cell according to the embodiment of the present invention;
Figs. 5(a) and 5(b) are plan views of a thin-film photovoltaic cell according to a second embodiment of the present invention, Fig. 5(a) being a plan view showing the thin-film photovoltaic cell from the rear electrode layer side and Fig. 5(b) a plan view showing the thin-film photovoltaic cell from the first and second back electrode layers side;
Figs. 6(a) and 6(b) are plan views of a thin-film photovoltaic cell according to a third embodiment of the present invention, Fig. 6(a) being a plan view showing the thin-film photovoltaic cell from the rear electrode layer side and Fig. 6(b) a plan view showing the thin-film photovoltaic cell from the first and second back electrode layers side;
Fig. 7 is a plan view of a conventional thin-film photovoltaic cell;
Fig. 8(a) is a cross-sectional diagram taken along line A-A of Fig. 7, and Fig. 8(b) is an enlarged view of section C shown in Fig. 8(a); and
Fig. 9 (a) is a cross-sectional diagram taken along a line B-B of Fig. 7, and Fig. 9(b) is an enlarged view of section D shown in Fig. 9(a).

### BEST MODE FOR CARRYING OUT THE INVENTION

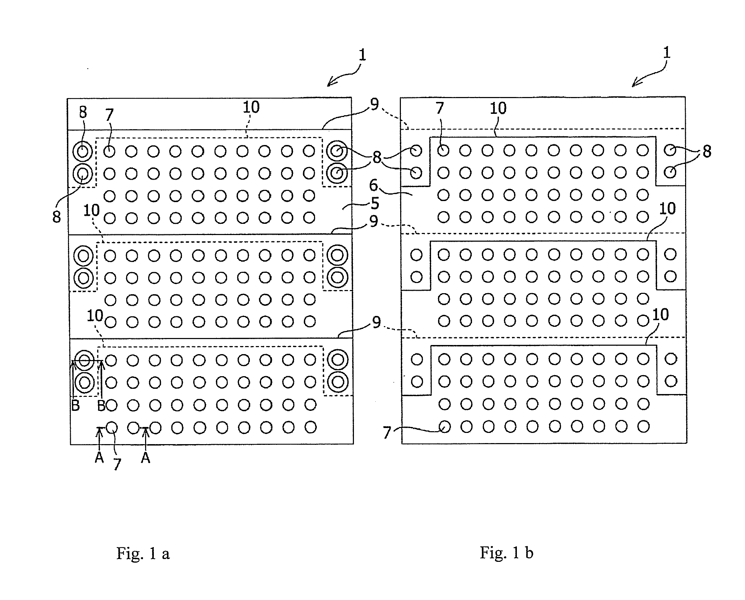

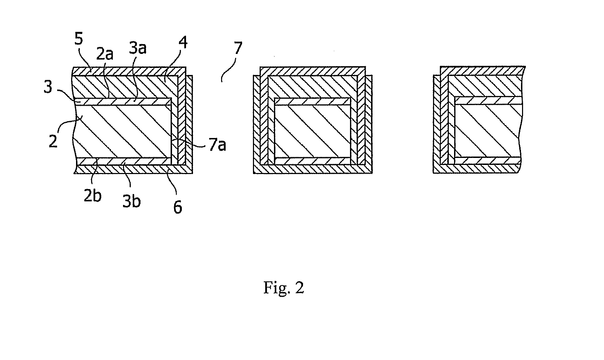

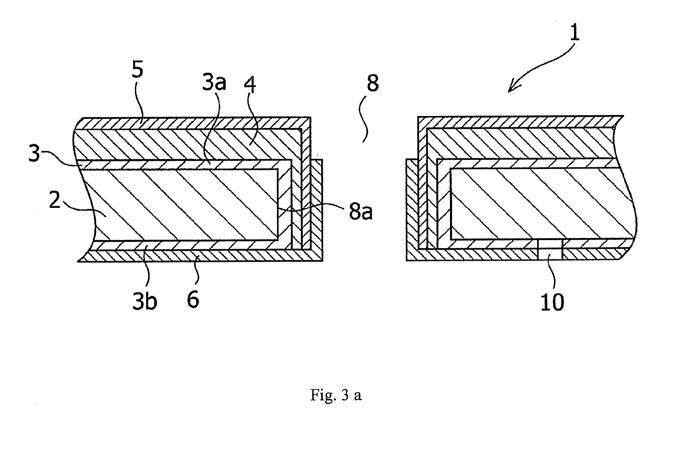

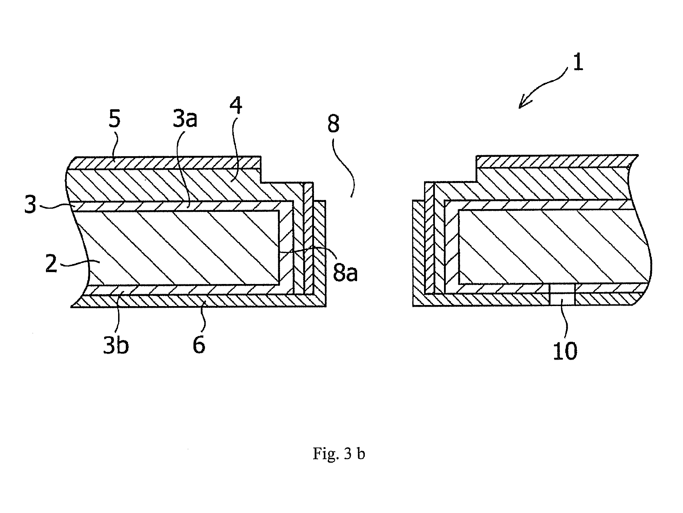

Thin-film photovoltaic cells according to embodiments of the present invention are described hereinafter with reference to the drawings. Fig. 1 is a plan view of a thin-film photovoltaic cell according to a first embodiment. Fig. 2 is a cross-sectional diagram taken along line A-A of Fig. 1. Fig. 3 is a cross-sectional diagram taken along line B-B of Fig. 1.

### [First Embodiment]

As shown in Figs. 1 to 3, a thin-film photovoltaic cell 1 according to the present embodiment has an insulating substrate 2. The insulating substrate 2 is formed from a film material of, for example, polyimide, polyamideimide, polyethylenenaphthalate, or aramid.

As shown in Fig. 2, a metal electrode layer 3 containing metal is formed on either surface 2a, 2b of the insulating substrate 2. The metal electrode layer 3 on the surface 2a of the insulating substrate 2 functions as a rear electrode layer 3a, and the metal electrode layer 3 on the surface 2b of the insulating substrate 2 as a first back electrode layer 3b.

Also, as shown in Figs. 2 and 3, a photoelectric conversion layer 4 and a transparent electrode layer 5 are stacked, in this order, on the rear electrode layer 3a on the surface 2a of the insulating substrate 2. An amorphous semiconductor, amorphous compound conductor, dye-sensitized photovoltaic cell, or CIGS organic photovoltaic cell can be used s the photoelectric conversion layer 4. A second back electrode layer 6 is stacked on the first back electrode layer 3b on the surface 2b of the insulating substrate 2.

As shown in Fig. 1, the insulating substrate 2 is provided with first through-holes 7 penetrating through the insulating substrate 2. As shown in Fig. 2, the transparent electrode layer 5 and the second back electrode layer 6 are connected to each other so as to overlap on each other at side wall parts 7a of the first through-holes 7.
As shown in Fig. 1, the insulating substrate 2 is provided with second through-holes 8 penetrating through the insulating substrate 2. In the present embodiment, the second through-holes 8 are formed in pairs at equal intervals at either end part of the insulating substrate 2 of the thin-film photovoltaic cell 1 in a width direction of the insulating substrate 2. Furthermore, as shown in Fig. 3, the rear electrode layer 3a and the first back electrode layer 3b are electrically connected to each other by side wall parts 8a of the second through-holes 8.
The first and second through-holes 7 and 8 are used for connecting the first and second back electrode layers 3b and 6, the first through-holes 7, the transparent electrode layer 5, the photoelectric conversion layer 4, the rear electrode layer 3a, the second through-holes 8, and the first back electrode layer 3b, in this order.

As shown in Fig. 1, the layers stacked on the surface 2a of the insulating substrate 2 (the rear electrode layer 3a, the photoelectric conversion layer 4, and the transparent electrode layer 5) are laser-processed and thereby divided into a plurality of pieces by first patterning lines 9. Similarly, as shown in Figs. 1 and 3, the layers stacked on the surface 2b of the insulating substrate 2 (the first back electrode layer 3b and the second back electrode layer 6) are laser-processed and thereby divided into a plurality of pieces by second patterning lines 10. The first patterning lines 9 and the second patterning lines 10 alternate with each other in the insulating substrate 2.
The insulating substrate 2 is divided into unit cells (unit photovoltaic cells) formed of the layers stacked on the surfaces 2a and 2b of the insulating substrate 2 by the first and second patterning lines 9 and 10. In other words, the positions where the electrode layers on the surfaces 2a and 2b of the insulating substrate 2 are separated are shifted, and the electrode layers on the surfaces 2a and 2b of the insulating substrate 2 are connected to one another by second through-holes 28, so that the unit cells adjacent to each other are connected in series.
In Fig. 1, the second patterning lines 10 where the layers on the back of the insulating substrate 2 are removed are bent. Specifically, in the present embodiment, each of the second patterning lines 10 is bent 90° twice. In the present embodiment, a unit photoelectric conversion part and unit rear electrode layer constituting each unit cell (unit photovoltaic cell) are substantially aligned, with the insulating substrate 2 therebetween. Therefore, with no limitations on the positions for forming the first through-holes 7 in each unit cell (without forming the first through-holes 7 in an unbalanced manner), a desired number of first through-holes 7 can be formed in desired positions in accordance with a condition for producing the thin-film photovoltaic cell, improving current collection efficiency.
The shape of the second patterning lines 10 may not only be the shape illustrated in the present embodiment but also be a shape including a curve, such an obliquely bent structure. Furthermore, the second patterning lines 10 may be straight lines, whereas the first patterning lines 9 have bent parts. Or, both the first patterning lines 9 and the second patterning lines 10 may have bent parts.

The present embodiment is characterized in that the periphery of each second through-hole 8 is processed in order to partially remove the transparent electrode layer 5 around each second through-holes 8, as shown in Fig. 3(b). Therefore, the transparent electrode layer 5 and the second back electrode layer 6 are electrically connected to each other at the second through-holes 8. Consequently, the transparent electrode layer 5 and the first back electrode layer 3b are electrically insulated from each other at the second through-holes 8.
In terms of performing precision fabrication on the periphery of each second through-hole 8, it is effective to sandblast the periphery of each second through-hole 8. The method for fabricating the periphery of each second through-hole 8 is not limited to sandblasting as long as the properties of the thin-film photovoltaic cell 1 are not degraded. The method for fabricating may be able to perform counterboring without causing thermal denaturation in the photoelectric conversion layer 4 and includes, for example, cutting, dry etching, and wet etching. When sandblasting the periphery of each second through-hole 8, the fabrication range can be determined by spraying sand locally without using a mask.

In the thin-film photovoltaic cell 1 according to the present embodiment, the film material described is used as the insulating substrate 2. A roll-to-roll printing process or an inkj et printing technique is used as a method for producing the thin-film photovoltaic cell 1. For instance, the roll-to-roll printing process conveys substrates made from a film material by using a plurality of rollers (conveying means) and continuously forms thin films on the substrates in film-forming chambers that are disposed continuously.

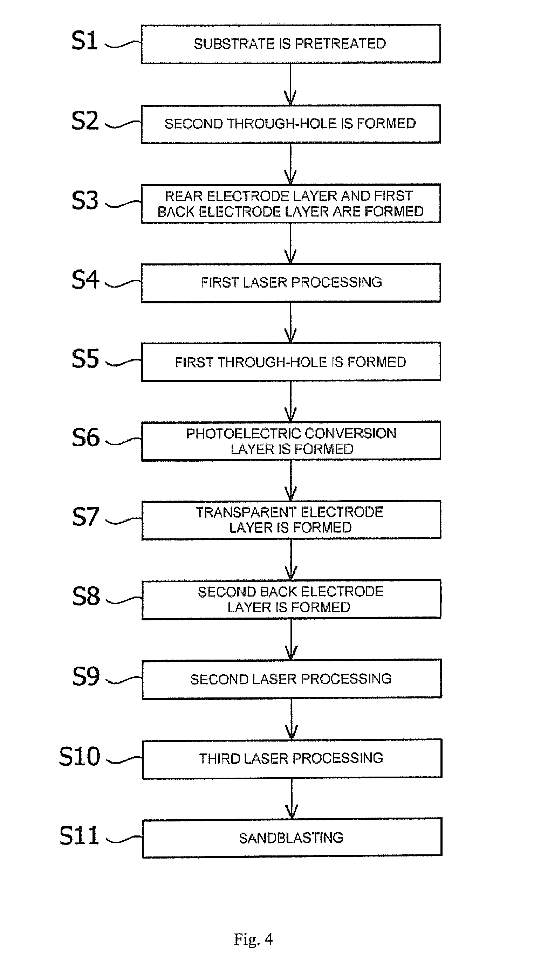

The method for producing a thin-film photovoltaic cell according to the embodiment of the present invention is described next with reference to the drawings. Fig. 4 is a flowchart of a procedure for producing the thin-film photovoltaic cell 1 according to the present embodiment.

In production of the thin-film photovoltaic cell 1, first, the insulating substrate 2 is pretreated in step S1, as shown in Fig. 4. More specifically, when pretreating the insulating substrate 2, the insulating substrate 2 is exposed to a plasma to cleanse the surfaces thereof.

In the next step S2, the second through-holes 8 are formed in the insulating substrate 2. The second through-holes 8 are punched (a perforating method). The shape of each second through-hole 8 is a circular shape with a diameter of 1 mm. The diameter of each circular second through-hole 8 is set within a range of 0.05 to 1 mm. In the present embodiment, the second through-holes 8 are formed in pairs at equal intervals at either end part of the insulating substrate 2 of the thin-film photovoltaic cell 1 in the width direction of the insulating substrate 2. Note that the number of second through-holes 8 to be punched can be adjusted depending on the design.

In the subsequent step S3, sputtering is performed to form the rear electrode layer 3a and the first back electrode layer 3b on the surfaces 2a and 2b of the insulating substrate 2, respectively. In so doing, the rear electrode layer 3a and the first back electrode layer 3b are electrically connected to each other by the second through-holes 8.
Thereafter, in step S4, the layers formed on the surfaces 2a and 2b of the insulating substrate 2 are laser-processed and removed to form primary patterning lines (not shown). In so doing, the lines formed on the surfaces 2a and 2b of the insulating substrate 2 are disposed alternately.
In step S5, the first through-holes 7 are formed in the insulating substrate 2. The first through-holes 7 are punched. Subsequently, the insulating substrate 2 is heated to a certain temperature or higher that is used in a subsequent step (step S6 for forming the photoelectric conversion layer 4, the transparent electrode layer 5, and the like). Specifically, the insulating substrate 2 is heated to 250°C or higher, or preferably 300°C or higher. This can prevent the layers formed in the subsequent steps from peeling off.

In step S6, the photoelectric conversion layer 4 is formed on the rear electrode layer 3a of the insulating substrate 2. Thereafter in step S7, the transparent electrode layer 5 is formed on the photoelectric conversion layer 4.
In the subsequent step S8, the second back electrode layer 6 is formed on the first back electrode layer 3b of the insulating substrate 2.

In the subsequent step S9, the photoelectric conversion layer 4 and the transparent electrode layer 5 on the primary patterning lines formed in step S4 are laser-processed and removed again, to form the first patterning lines 9.
Further, in step S10, the second back electrode layer 6 on the primary patterning line formed in step S4 is laser-processed and removed again, to form the second patterning lines 10. The layers on the insulating substrate 2 are separated into a plurality of unit cells by the first and second patterning lines 9 and 10.

In the subsequent step S11, the periphery of each second through-hole 8 is sandblasted to remove a conductive film including the transparent electrode layer 5. In so doing, although not shown, the second back electrode layer 6 is removed as well because the second back electrode layer 6 might be wrapped around on the transparent electrode layer 5. As a result of the sandblasting processing, a counterbore diameter, which is larger than the diameter of each second through-hole 8 by approximately 0.1 to 1 mm, is formed around each second through-hole 8. The fabrication is performed to the level as deep as the middle of the photoelectric conversion layer 4 so as to keep the photoelectric conversion layer 4. This fabrication may scrape off the photoelectric conversion layer 4 completely, but it is preferred that the rear electrode layer 3a be kept entirely without being damaged as much as possible, so that the resistances do not increase.
In this manner the series connection of the thin-film photovoltaic cell 1 is completed.

In the thin-film photovoltaic cell 1 according to the first embodiment of the present invention, the rear electrode layer 3a, the photoelectric conversion layer 4, and the transparent electrode layer 5 are stacked, in this order, on the surface 2a of the insulating substrate 2, and the first back electrode layer 3b and the second back electrode layer 6 are stacked, in this order, on the surface 2b of the insulating substrate 2. The first and second patterning lines 9 and 10 are formed alternately on the layers stacked on the surfaces 2a and 2b of the insulating substrate 2, thereby dividing the insulating substrate 2 into a plurality of unit cells. The transparent electrode layer 5 and the second back electrode layer 6 are electrically connected to each other by the first through-holes 7 penetrating through the insulating substrate 2. The rear electrode layer 3a and the first back electrode layer 3b are electrically connected to each other by the second through-holes 8 penetrating through the insulating substrate 2. The unit cells adj acent to each other are connected in series. The transparent electrode layer 5 around each of the second through-holes 8 is removed, and the transparent electrode layer 5 and the second back electrode layer 6 are electrically insulated from each other at the second through-holes 8. Therefore, without performing the mask processing around the second through-holes as in the conventional technologies, insulation between the transparent electrode layer 5 and the second back electrode layer 6 can be ensured at the second through-holes 8. In addition, because the transparent electrode layer 5 is simply removed without performing the mask processing on the periphery of each of the second through-holes 8, the area of a region without the transparent electrode layer 5 is smaller than that obtained as a result of the mask processing. Thus, the effective area of the transparent electrode layer 5 can be made wider than those of the conventional technologies. As a result, the output of the thin-film photovoltaic cell 1 can be increased.

The method for producing the thin-film photovoltaic cell 1 according to the first embodiment of the present invention includes the steps of: forming the second through-holes 8 in the insulating substrate 2; forming the rear electrode layer 3a on the surface 2a of the insulating substrate 2 and forming the first back electrode layer 3b on the surface 2b of the insulating substrate 2; forming the first through-holes 7 in the insulating substrate 2 after forming the rear electrode layer 3a and the first back electrode layer 3b; stacking the photoelectric conversion layer 4 and the transparent electrode layer 5 on the surface 2a of the insulating substrate 2 in this order and stacking the second back electrode layer 6 on the surface 2b of the insulating substrate 2; forming the first and second patterning lines 9 and 10 alternately on the layers stacked on the surfaces 2a and 2b of the insulating substrate 2 and dividing the insulating substrate 2 into a plurality of unit cells; and removing the transparent electrode layer 5 around the second through-holes 8 and electrically insulating the transparent electrode layer 5 and the second back electrode layer 6 from each other at the second through-holes 8. For this reason, unlike in the conventional technologies, the mask processing does not have to be performed in the vicinity of the second through-holes, improving the yield of production of the thin-film photovoltaic cell 1. Moreover, since the mask processing does not have to be performed in the vicinity of the second through-holes 8, the layers on the insulating substrate 2 can be prevented from being damaged by contact between the mask and the layers on the insulating substrate 2. Consequently, increase in leak current in the thin-film photovoltaic cell 1 can be prevented, lowering the failure rate in manufacturing the thin-film photovoltaic cell 1.

### [Second Embodiment]

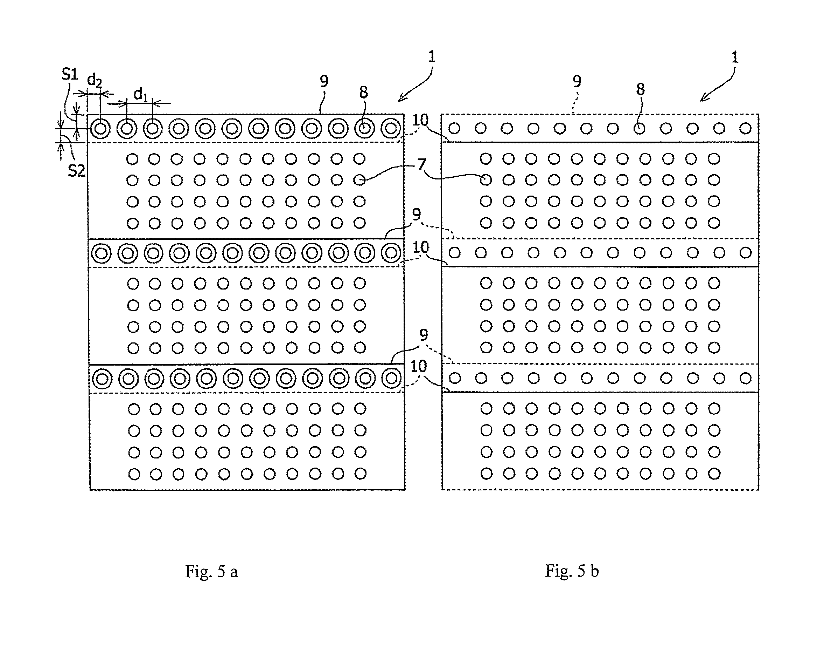

The thin-film photovoltaic cell 1 according to a second embodiment of the present invention is described hereinafter with reference to the drawings. Figs. 5(a) and 5(b) are plan views of the thin-film photovoltaic cell according to the second embodiment, Fig. 5(a) being a plan view showing the thin-film photovoltaic cell from the rear electrode layer side and Fig. 5(b) a plan view showing the thin-film photovoltaic cell from the first and second back electrode layers side. Note that the same reference numerals are applied to the sections same as those described in the above embodiment. Therefore, the overlapping descriptions are omitted.

In the second embodiment, the first patterning lines 9 and the second patterning lines 10 are formed into straight lines and extend in a direction parallel to the width direction of the insulating substrate 2, as shown in Fig. 5. Also, a plurality of second through-holes 8 are disposed in a line between the alternating first and second patterning lines 9 and 10.
The plurality of second through-holes 8 are disposed at an interval of d₁. A distance d₂ between an end part of the insulating substrate 2 in the width direction and the center of the second through-hole 8 closest to this end part is half the interval d₁ of the second through-holes.

As shown in Fig. 5, a region around each second through-hole 8 where the transparent electrode layer 5 is not formed falls within a range between each first patterning line 9 and each second patterning line 10 that alternate with each other. Moreover, a distance S₁ between the center of the second through-hole 8 and the first patterning line 9 is equal to a distance S₂ between the center of the second through-hole 8 and the second patterning line 10.

In the conventional structures, because the interval between the adjacent second through-holes was large in consideration of the mask processing and electrical resistances, the distance between the wirings in each unit cell was long. In addition, due to the large interval between the second through-holes, more current concentrates on a single second through-hole. This results in a voltage drop and loss of the output of the thin-film photovoltaic cell.
In the thin-film photovoltaic cell 1 of the second embodiment, however, the region around each second through-hole 8 where the transparent electrode layer 5 is not formed is smaller than those obtained in the conventional technologies. Therefore, a plurality of the second through-holes can be disposed at intervals shorter than those obtained in the conventional technologies, as shown in Fig. 5. Consequently, the concentration of current in the second through-holes 8 can be dispersed, preventing the loss of the output of the thin-film photovoltaic cell 1. Moreover, even when the plurality of second through-holes 8 are provided in a single unit cell, the output of the thin-film photovoltaic cell 1 can be made higher than those in the conventional technologies. Additionally, the distance between the wirings and the thickness of the wiring materials can be made reduced, accomplishing cost reduction.

### [Third Embodiment]

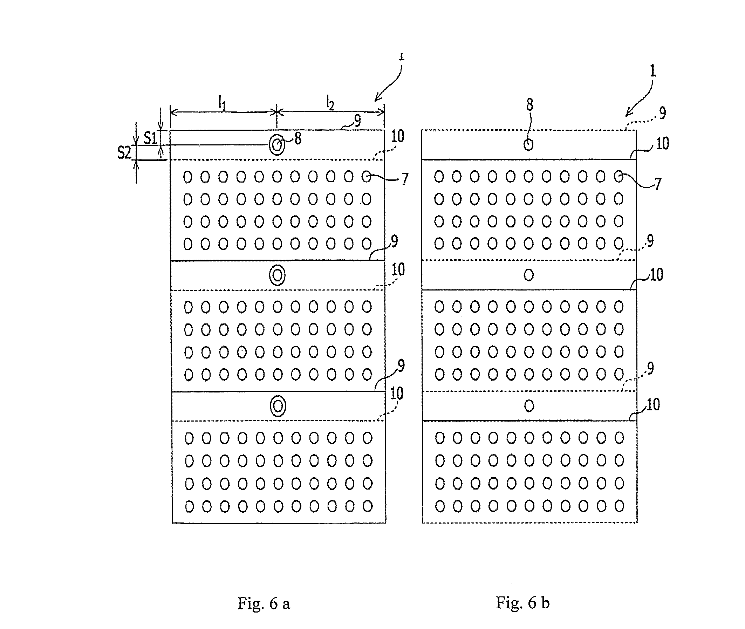

The thin-film photovoltaic cell 1 according to a third embodiment of the present invention is described hereinafter with reference to the drawings. Figs. 6(a) and 6(b) are plan views of the thin-film photovoltaic cell according to the third embodiment of the present invention, Fig. 6 (a) being a plan view showing the thin-film photovoltaic cell from the rear electrode layer side and Fig. 6(b) a plan view showing the' thin-film photovoltaic cell from the first and second back electrode layers side. Note that the same reference numerals are applied to the sections same as those described in the above embodiment. Therefore, the overlapping descriptions are omitted.

In the third embodiment, the first patterning lines 9 and the second patterning lines 10 are formed into straight lines and extend in a direction parallel to the width direction of the insulating substrate 2, as shown in Fig. 6. Also, only one second through-hole 8 is disposed between each of the first patterning lines 9 and each of the second patterning lines 10, the first and second patterning lines 9 and 10 being disposed alternately.
A distance l₁ between the center of the second through-hole 8 and one of end parts of the insulating substrate 2 in the width direction is equal to a distance l₂ between the center of the second through-hole 8 and the other end part of the insulating substrate 2 in the width direction. Furthermore, a distance S₁ between the center of the second through-hole 8 and the first patterning line 9 is equal to a distance S₂ between the center of the second through-hole 8 and the second patterning line 10.

The thin-film photovoltaic cell 1 of the third embodiment is particularly useful in a thin-film photovoltaic cell in which the width direction of the insulating substrate 2 is short and a plurality of cells are disposed in the width direction of the insulating substrate 2. According to this configuration, the effective area of the transparent electrode layer 5 can be increased by simply removing the transparent electrode layer 5 around the second through-hole 8. In addition, disposing the plurality of cells in the width direction of the insulating substrate 2 can prevent the increase of the electrical resistances of the first and second back electrode layers 3b and 6.

The above has described the embodiments of the present invention. However, the present invention is not limited to these embodiments; thus, various modifications and changes can be made based on the technical idea of the present invention.

In the embodiments described above, the step of removing the conductive film including the transparent electrode layer 5 (S11) is executed at the end. However, step S11 can be executed any time after step S8.

### EXPLANATION OF REFERENCE NUMERALS

- 1: Thin-film photovoltaic cell
- 2: Insulating substrate
- 3: Metal electrode layer
- 3a: Rear electrode layer
- 3b: First back electrode layer
- 4: Photoelectric conversion layer
- 5: Transparent electrode layer
- 6: Second back electrode layer
- 7: First through-hole
- 8: Second through-hole
- 9: First patterning line
- 10: Second patterning line

## Claims

1. A thin-film photovoltaic cell, comprising:
an insulating substrate;
a rear electrode layer, a photoelectric conversion layer, and a transparent electrode layer stacked in this order on one surface of the insulating substrate;
a first back electrode layer and a second back electrode layer stacked in this order on the other surface of the insulating substrate;
patterning lines that are formed alternately on the layers stacked on both surfaces of the insulating substrate, thereby dividing the insulating substrate into a plurality of unit cells;
a first through-hole that penetrates through the insulating substrate to electrically connect the transparent electrode layer and the second back electrode layer to each other; and
a second through-hole that penetrates through the insulating substrate to electrically connect the rear electrode layer and the first back electrode layer to each other,
the unit cells adjacent to each other being connected in series,
wherein the transparent electrode layer around the second through-hole is removed, and the transparent electrode layer and the second back electrode layer are electrically insulated from each other at the second through-hole.

2. The thin-film photovoltaic cell according to claim 1, wherein the transparent electrode layer around the second through-hole is removed by sandblasting.

3. The thin-film photovoltaic cell according to claim 1 or 2, wherein
the patterning lines that are disposed alternately are formed into straight lines and extend in a direction parallel to a width direction of the insulating substrate,
a plurality of the second through-holes are disposed at equal intervals between the patterning lines that are disposed alternately,
a distance between an end part of the insulating substrate in the width direction and a center of the second through-hole closest to the end part is half the interval between the second through-holes, and
a distance between the center of the second through-hole and either one of the patterning lines is equal to a distance between the center of the second through-hole and another patterning line.

4. The thin-film photovoltaic cell according to claim 1 or 2, wherein
the patterning lines that are disposed alternately are formed into straight lines and extend in a direction parallel to a width direction of the insulating substrate,
the second through-hole is disposed singly between the patterning lines that are disposed alternately,
a distance between a center of the second through-hole and one end part of the insulating substrate in the width direction is equal to a distance between the center of the second through-hole and the other end part of the insulating substrate in the width direction, and
a distance between the center of the second through-hole and either one of the patterning lines is equal to a distance between the center of the second through-hole and another patterning line.

5. A method for producing a thin-film photovoltaic cell, comprising the steps of:
forming a second through-hole in an insulating substrate;
forming a rear electrode layer on one surface of the insulating substrate and forming a first back electrode layer on the other surface of the insulating substrate;
forming a first through-hole in the insulating substrate after forming the rear electrode layer and the first back electrode layer;
stacking a photoelectric conversion layer and a transparent electrode layer on the one surface of the insulating substrate in this order and stacking a second back electrode layer on the other surface of the insulating substrate;
forming patterning lines alternately on the layers stacked on both surfaces of the insulating substrate and dividing the insulating substrate into a plurality of unit cells; and
removing the transparent electrode layer around the second through-hole and electrically insulating the transparent electrode layer and the second back electrode layer from each other at the second through-hole.

6. The method for producing a thin-film photovoltaic cell according to claim 5, wherein the step of removing the transparent electrode layer around the second through-hole is performed by sandblasting.

7. The method for producing a thin-film photovoltaic cell according to claim 5 or 6, wherein
the step of forming a second through-hole forms a plurality of the second through-holes at equal intervals between positions where the alternating patterning lines are formed,
the patterning lines are formed into straight lines in a direction parallel to a width direction of the insulating substrate,
a distance between an end part of the insulating substrate in the width direction and a center of the second through-hole closest to the end part is half the interval between the second through-holes, and
a distance between the center of the second through-hole and either one of the patterning lines is equal to a distance between the center of the second through-hole and another patterning line.

8. The method for producing a thin-film photovoltaic cell according to claim 5 or 6, wherein
the step of forming a second through-hole forms one second through-hole between positions where the alternating patterning lines are formed,
the patterning lines are formed into straight lines in a direction parallel to a width direction of the insulating substrate,
a distance between a center of the second through-hole and one end part of the insulating substrate in the width direction is equal to a distance between the center of the second through-hole and the other end part of the insulating substrate in the width direction, and
a distance between the center of the through-hole and either one of the patterning lines is equal to a distance between the center of the through-hole and another patterning line.
